Europäisches Patentamt

European Patent Office

Office européen des brevets

(11) Veröffentlichungsnummer: **0 401 947**

**A2**

(12) **EUROPÄISCHE PATENTANMELDUNG**

(21) Anmeldenummer: 90250144.4

(22) Anmeldetag: 01.06.90

(51) Int. Cl.5: **H03C 3/09**

(30) Priorität: 07.06.89 DE 3918581

(43) Veröffentlichungstag der Anmeldung:
12.12.90 Patentblatt 90/50

(84) Benannte Vertragsstaaten:
AT BE CH DE DK ES FR GB GR IT LI LU NL SE

(71) Anmelder: **ROBERT BOSCH GMBH**
**Postfach 10 60 50**
**D-7000 Stuttgart 10(DE)**

(72) Erfinder: **Schulz, Hans-Jürgen**
**Nogatstrasse 18**
**D-1000 Berlin 44(DE)**
Erfinder: **Wegener, Klaus-Dieter, Dipl.-Ing.**
**Hundekehlestrasse 5**
**D-1000 Berlin 33(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**D-1000 Berlin 33(DE)**

(54) **Durch eine niederfrequente, analoge Modulationsspannung modulierbare PLL-Oszillatorschaltung.**

(57)
2.1 Bekannte, durch eine niederfrequente, analoge Modulationsspannung modulierbare PLL-Oszillatorschaltungen haben den Nachteil, daß die tieferfrequenten Anteile der Modulationsspannung bei dem Regelvorgang mitausgeregelt werden.

2.2 Um diesen Nachteil zu vermeiden, wird die niederfrequente Modulationsspannung ($U_{NF}$) integriert und invertiert als Kompensationsspannung ($U_K$) einem Eingang (30) eines ersten Spannungsaddierers (14) zugeführt, an dessen zweiten Eingang (13) die von einem Phasendiskriminator (11) gelieferte Fehlerspannung ($U_F$) liegt. Die derart beeinflußte Fehlerspannung wird über ein Schleifenfilter (16) ebenso wie die niederfrequente Modulationsspannung einem Steuereingang (20) eines spannungsgesteuerten Oszillators (22) zugeführt.

2.3 Ein bevorzugtes Anwendungsgebiet für die modulierbare PLL-Oszillatorschaltung ist ein mehrkanaliges Sprechfunkgerät.

3. Die Zeichnung zeigt ein Blockschaltbild der modulierbaren PLL-Oszillatorschaltung.

EP 0 401 947 A2

Die Erfindung betrifft eine modulierbare PLL-Oszillatorschaltung nach dem Oberbegriff des Anspruchs 1.

## Stand der Technik

Es sind durch eine niederfrequente, analoge Modulationsspannung modulierbare PLL-Oszillatorschaltungen bekannt. Um eine hohe Kurzzeitstabilität der von dem Oszillator abgegebenen Frequenz auch bei Störungen, die zum Beispiel auf Temperaturänderungen oder Mikrofonieeffekte und dergleichen zurückzuführen sind, zu erreichen, wird eine möglichst schnelle Fehlerausregelung angestrebt, die in bekannter Weise durch PI-Regler höherer Ordnung realisiert wird. Nun stellt aber auch die Frequenz- bzw. Phasenmodulation der Oszillatorfrequenz eine Störung für die Regelschleife dar, die im Bereich der tieferen niederfrequenten Modulationsfrequenzen mitausgeregelt würde.

## Aufgabe

Der Erfindung liegt die Aufgabe zugrunde, eine modulierbare PLL-Oszillatorschaltung gemäß dem Oberbegriff des Anspruchs 1 derart weiterzubilden, daß sie trotz schneller Fehlerausregelung die niederfrequente Modulation zu den tieferen Modulationsfrequenzen hin nicht mitausregelt.

## Lösung

Diese Aufgabe wird bei einer modulierbaren PLL-Oszillatorschaltung gemäß dem Oberbegriff des Anspruchs 1 durch die im kennzeichnenden Teil dieses Anspruchs angegebenen Merkmale gelöst. Die mit der Erfindung erzielbaren Vorteile bestehen insbesondere darin, daß sowohl ein schnelles Ansprechen auf Störungen und ein schnelles Einschwingen der PLL-Oszillatorschaltung auf den Sollwert erreicht wird, als auch ein linearer Frequenzgang der Phasen- bzw. Frequenzmodulation bis weit unter die Eigenfrequenz der Regelschleife realisierbar ist.

Ein bevorzugtes Anwendungsgebiet für die Erfindung ist ein Vielkanal-Sprechfunkgerät.

## Beschreibung

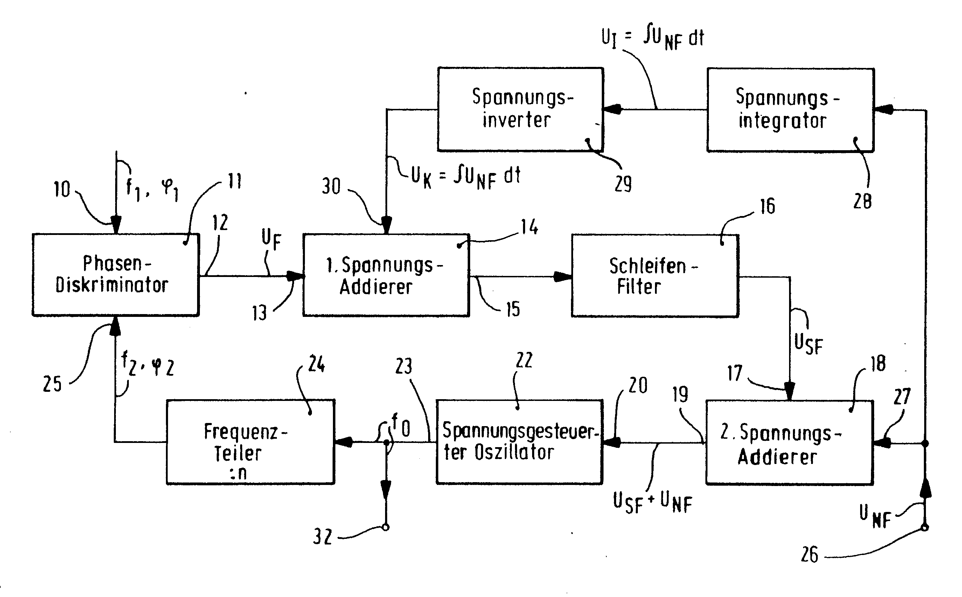

Ein Ausführungsbeispiel der Erfindung ist in der Zeichnung anhand einer einzigen Figur dargestellt und wird im folgenden näher beschrieben. In der Figur, die ein Blockschaltbild einer modulierbaren PLL-Oszillatorschaltung zeigt, bezeichnet 10 einen ersten Eingang eines Phasendiskriminators 11, dessen Ausgang 12 mit einem ersten Eingang 13 eines ersten Spannungsaddierers 14 verbunden ist. Ein Ausgang 15 des ersten Spannungsaddierers 14 steht über ein Schleifenfilter 16 mit einem ersten Eingang 17 eines zweiten Spannungsaddierers 18 in Verbindung, dessen Ausgang 19 mit einem Steuereingang 20 eines spannungsgesteuerten Oszillators 22 verbunden ist. Ein Ausgang 23 des spannungsgesteuerten Oszillators 22 ist über einen Frequenzteiler 24 mit einem zweiten Eingang 25 des Phasendiskriminators 11 verbunden. Ein Modulationseingang 26 der PLL-Oszillatorschaltung ist erstens mit einem zweiten Eingang 27 des zweiten Spannungsaddierers 18 und zweitens über einen Spannungsintegrator 28 mit einem Spannungsinverter 29 verbunden, an den sich ein zweiter Eingang 30 des ersten Spannungsaddierers 14 anschließt. Der Ausgang der PLL-Oszillatorschaltung ist mit 32 bezeichnet.

Die Wirkungsweise der vorstehend beschriebenen modulierbaren PLL-Oszillatorschaltung ist folgende.

An dem ersten Eingang 10 des Phasendiskriminators 11 liegt zum Beispiel eine quarzstabilisierte Referenzfrequenz $f_1$ mit einer Phasenlage $\phi_1$ Der spannungsgesteuerte Oszillator 22 liefert eine Oszillatorfrequenz $f_0 = f_M \pm \Delta f$, wobei $f_M = n \cdot f_2$ die Mittenfrequenz des Oszillators und $\Delta f$ die durch die Frequenz der Modulationsspannung $U_{NF}$ verursachte Frequenzänderung ist. Zunächst wird davon ausgegangen, daß an dem Eingang 26 noch keine Modulationsspannung $U_{NF}$ liegt, so daß die Oszillatorfrequenz $f_0$ der Mittenfrequenz $f_M$ entspricht. Durch eine Frequenzteilung mit dem Frequenzteiler 24, der ein vorzugsweise stufenweise einstellbares Teilerverhältnis von 1 : n aufweist, erhält man eine Frequenz $f_2$, die der Frequenz $f_1$ entspricht, die jedoch zunächst eine zum Beispiel von der Phasenlage $\phi_1$ abweichende Phasenlage $\phi_2$ aufweist.

Durch den Phasenvergleich von $\phi_1$ und $\phi_2$ mit dem Phasendiskriminator 11 wird eine Fehlerspannung $U_F$ erhalten, die mittels des Schleifenfilters 16 gefiltert dem Steuereingang 20 des spannungsgesteuerten Oszillators 22 zugeführt wird. Der Oszillator wird dadurch derart gesteuert, daß sich der Phasenunterschied zwischen $\phi_1$ und $\phi_2$ solange verringert, bis die Regelschleife einrastet.

Damit sich der Regelvorgang nicht auf die tieferen Frequenzen der Modulationsspannung $U_{NF}$ auswirkt, wird die Modulationsspannung $U_{NF}$ mit dem Spannungsintegrator 28 zu einer Spannung $U_i = \int U_{NF} \, dt$ integriert, und das Ergebnis wird mit dem Spannungsinverter 29 invertiert.

Die durch die Integration und die Invertierung erhaltene Kompensationsspannung $U_K$ wird dem zweiten Eingang 30 des ersten Spannungsaddierers 14 zugeführt. Durch die Addition kompensiert die Kompensationsspannung $U_K$ den Anteil der Fehlerspannung $U_F$, der auf die niederfrequenten Modulationsfrequenzen zurückgeht. Die untere Grenze des Frequenzgangs wird somit nicht mehr durch die Hochpaßfunktion des Regelkreises begrenzt, so daß annähernd beliebig tiefe Modulationsfrequenzen angewendet werden dürfen. Die Sprungantwort bei tiefer impulsförmiger Modulation erfährt dabei fast keine Veränderung.

## Ansprüche

Durch eine niederfrequente, analoge Modulationsspannung modulierbare PLL-Oszillatorschaltung, die einen Phasendiskriminator, ein Schleifenfilter und einen spannungsgesteuerten Oszillator enthält, **dadurch gekennzeichnet,** daß die Modulationsspannung ($U_{NF}$) mittels eines Spannungsintegrators (28) integriert, daß die integrierte Modulationsspannung mittels eines Spannungsinverters (29) invertiert und daß die invertierte Spannung ($U_K$) der Fehlerspannung ($U_F$) am Ausgang des Phasendiskriminators zwecks Kompensation des durch die Modulation erzeugten Anteils der Fehlerspannung hinzugefügt wird.

EP 0 401 947 A2

$$U_I = \int U_{NF}\, dt$$

| | |
|---|---|
| Spannungs-inverter | Spannungs-integrator |

29     28

10   $f_1,\ \varphi_1$   11     30    $U_K = \int U_{NF}\, dt$

16

12   $U_F$      14

| Phasen-Diskriminator | 1. Spannungs-Addierer | Schleifen-Filter |
|---|---|---|

13     15

$f_2,\ \varphi_2$     $U_{SF}$

25     24    23    22    20   19   17    18    27

| Frequenz-Teiler :n | Spannungsgesteuer-ter Oszillator | 2. Spannungs-Addierer |
|---|---|---|

$f_0$

$U_{SF} + U_{NF}$

32     $U_{NF}$

26